(19) **Europäisches Patentamt**
**European Patent Office**
**Office européen des brevets**

(11) **EP 2 618 439 B1**

(12) **EUROPÄISCHE PATENTSCHRIFT**

(45) Veröffentlichungstag und Bekanntmachung des Hinweises auf die Patenterteilung:
**12.10.2016   Patentblatt 2016/41**

(51) Int Cl.:
*H02H 3/087* (2006.01)      *H02H 7/18* (2006.01)
*H01M 10/44* (2006.01)      *G01R 31/36* (2006.01)
*G01R 31/40* (2006.01)      *G01R 19/165* (2006.01)
*H01H 47/00* (2006.01)

(21) Anmeldenummer: **12008364.7**

(22) Anmeldetag: **15.12.2012**

(54) **Schutzschaltung für einen Akkupack**

Protective circuit for a battery pack

Circuit protecteur pour une batterie

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2011   DE 102011121934**

(43) Veröffentlichungstag der Anmeldung:
**24.07.2013   Patentblatt 2013/30**

(73) Patentinhaber: **Andreas Stihl AG & Co. KG**
**71336 Waiblingen (DE)**

(72) Erfinder:
• **Gaul, Henrik**
**D-73614 Schorndorf (DE)**

• **Schurr, Martin**
**D-73557 Mutlangen (DE)**

(74) Vertreter: **Wasmuth, Rolf et al**
**Patentanwälte**
**Dipl.Ing. W. Jackisch & Partner mbB**
**Menzelstrasse 40**
**70192 Stuttgart (DE)**

(56) Entgegenhaltungen:
**EP-A2- 1 308 739       US-A1- 2004 138 785**
**US-A1- 2011 003 182       US-A1- 2011 074 354**

**Beschreibung**

Die Erfindung betrifft eine Schutzschaltung für eine Anordnung aus einer Vielzahl von Einzelzellen in einem Akkupack, wobei eine vorgegebene Anzahl von Einzelzellen in einer Zellreihe hintereinander geschaltet sind.

Derartige Akkupackanordnungen aus z. B. chemisch auf Lithium basierenden Zellen werden bei handgetragenen Arbeitsgeräten verwendet und sollen bei hoher Leistung eine lange Betriebsdauer des über den Akkupack mit Energie versorgten Arbeitsgerätes sicherstellen. Ein großer Zellverbund ist nur so gut wie seine schwächste Zelle; altert eine Einzelzelle schneller als andere, wird die die schwächere Zelle enthaltende Zellreihe insgesamt beeinträchtigt, insbesondere können auch innerhalb des Akkupacks Ausgleichsströme fließen und die Leistungsfähigkeit des Akkupacks einschränken. Liegt eine defekte Einzelzelle vor, können innerhalb des Akkupacks auch dann Ausgleichsströme fließen, wenn keine äußere Last am Akkupack anliegt. Die gesunden Einzelzellen haben dadurch eine höhere Selbstentladung.

Aus der EP 1 308 739 A2, das den Oberbegriff des Anspruchs 1 bildet, ist ein Vergleich von Strangströmen parallel zueinander geschalteter Zellreihen bekannt, um nicht plausible Abweichungen der fließenden Ströme zu erkennen. In der US 2011/0003182 A1 wird vorgeschlagen, hierzu die Messung des Spannungsabfalls an einzelnen Zellen in einem Zellverbund zu nutzen. Wird eine nicht plausible Abweichung, also eine Abnormalität erkannt, wird als Reaktion in der US 2011/0074354 A1 vorgeschlagen, betroffene Zellreihen abzuschalten.

Der Erfindung liegt die Aufgabe zugrunde, eine Schutzschaltung für eine Anordnung aus einer Vielzahl von Einzelzellen in einem Akkupack derart auszubilden, dass ohne aufwendige Messungen der Ausfall bereits einer Einzelzelle in der gesamten Zellanordnung rasch und sicher erkannt werden kann.

Die Aufgabe wird nach den Merkmalen des Anspruchs 1 gelöst.

In jeder Zellreihe des Akkupacks ist ein gesteuerter Schalter vorgesehen, so dass ein Strang getrennt von anderen abgeschaltet werden kann. Liegen zumindest zwei Zellreihen zueinander parallel, teilt sich ein Belastungsstrom des Akkupacks in Strangströme der Zellreihen auf. Sind die Zellreihen gleich ausgebildet, teilt sich der Belastungsstrom gleich auf. Nach der Erfindung wird die an dem Schalter in einer Zellreihe abfallende Spannung als proportionale Größe zu einem fließenden Strangstrom erfasst und ausgewertet. Dadurch können ansonsten zur Strommessung notwendige Shunt-Widerstände entfallen. So kann der bei Belastung des Akkupacks in einer ersten Zellreihe in einem Zeitpunkt fließende Strangstrom mit dem in einer zweiten Zellreihe in dem gleichen Zeitpunkt fließende Strangstrom auf Übereinstimmung mit physikalischen Gesetzmäßigkeiten einfach verglichen werden; bei nicht plausibler Abweichung der Strangströme voneinander wird ein Signal generiert.

Bei einem derartigen Vergleich auf nicht plausible Abweichungen müssen die Messsignale nicht selbst z. B. durch Verwendung von Algorithmen, ausgewertet werden, sondern es reicht z. B. ein einfacher Vergleich der in einem gleichen Zeitpunkt erfassten Strangströme aus den parallelen Zellreihen. Weichen die Strangströme verschiedener Zellreihen in einem erheblichen Maße voneinander ab, sind also unterschiedlich, muss ein Fehler in einer der Zellreihen vorliegen, da aufgrund des gleichen konstruktiven Aufbaus der Zellreihen nur gleiche Stromwerte plausibel sind. Bei nicht plausibler Abweichung wird das Signal generiert, welches die Abweichung des Akkupacks vom normalen Betriebszustand wiedergibt und z. B. zum Abschalten des Akkupacks verwendet werden kann.

In einfacher Weise wird dann ein Signal generiert, wenn eine Differenz der Strangströme einen vorgegebenen Grenzwert überschreitet; vorteilhaft wird die Differenz aus den vorher normierten Strangströmen gebildet. Wird zwischen den in einem gleichen Zeitpunkt fließenden Strangströmen ein Differenzsignal gebildet, welches dann mit einem vorgegebenen Grenzwert verglichen wird, kann eine nicht plausible Abweichung erkannt werden. Bei gleich ausgebildeten Zellreihen wird der Grenzwert zu "Null" vorgegeben; weicht das Differenzsignal vom Grenzwert signifikant ab, ist die Plausibilität der Strangströme nicht mehr gegeben, und es wird ein Signal generiert.

Es kann vorteilhaft sein, das Verhältnis der Strangströme in einem Zeitpunkt t zueinander zu betrachten; auch aus dem Verhältnis kann unmittelbar auf die Plausibilität der Strangströme geschlossen werden. Ein zulässiges, plausibles Verhältnis liegt z. B. bei "Eins", sofern die in einem gleichen Zeitpunkt fließenden Strangströme in gleich aufgebauten Zellreihen miteinander verglichen werden. Weicht das errechnete Verhältnis signifikant von dem erwarteten Verhältnis "Eins" ab, ist die Plausibilität nicht mehr gegeben, und es wird ein Signal generiert.

Ein Plausibilitätsvergleich ist in einfacher Weise auch dadurch möglich, dass das Vorzeichen der Strangströme auf einen Vorzeichenwechsel untereinander überwacht wird. Es kann auch ausreichend sein, die nicht plausible Abweichung aus einem Vorzeichenwechsel der Vorzeichen des gleichen Strangstroms abzuleiten. Dies kann z. B. durch Verhältnisbildung des Strangstroms in einer ersten Zellreihe zu einem ersten Zeitpunkt mit dem Strangstrom der gleichen ersten Zellreihe zu einem zweiten Zeitpunkt erfolgen.

Da für den Plausibilitätsvergleich keine absoluten Werte notwendig sind, werden durch Normierung der erfassten Strangströme mit der Anzahl der in einer Zellreihe parallel liegenden Einzelzellen relative Werte gebildet, die einfach zu verarbeiten sind.

Eine weitere Möglichkeit eines Plausibilitätsvergleichs ist dadurch möglich, dass die Summe aller Strangströme in einem Zeitpunkt mit dem Gesamtstrom des Akkupacks in demselben Zeitpunkt verglichen wird. Zweckmäßig wird aus den Beträgen der Strangströme ein Summenstrom gebildet und mit dem Gesamtstrom verglichen; weichen der Summenstrom und der Gesamtstrom voneinander ab, ist die Plausibilität der Strangströme nicht mehr gegeben, und es wird ein entsprechendes Signal erzeugt.

In besonderer Weiterbildung der Erfindung wird aus allen in einem Zeitpunkt erfassten Strangströmen, insbesondere den normierten Strangströmen, ein maximaler Strangstrom festgestellt und für eine weitere Auswertung herangezogen. Hierzu wird jeweils ein Differenzstrom zwischen dem maximalen Strangstrom und jedem der anderen Strangströme ermittelt und die ermittelten Differenzströme mit einem Grenzwert verglichen. Wird der Grenzwert überschritten, wird ein Signal generiert.

Die Strangströme oder den Strangströmen entsprechende Messwerte werden vorteilhaft einer Auswerteeinheit zugeführt, in der die Prüfung der Plausibilität erfolgt und die bei nicht plausibler Abweichung ein Ausgangssignal abgibt.

Das von der Auswerteeinheit generierte Signal kann als Steuersignal verwendet werden, welches einen Schalter ansteuert.

Vorteilhaft werden als Schalter elektronische Schalter vorgesehen, insbesondere MOSFET's oder dgl. Bauelemente.

Ist der Akkupack aus mehr als zwei parallelen Zellreihen aufgebaut, werden die in allen Zellreihen fließenden Strangströme untereinander auf Plausibilität verglichen.

In Weiterbildung der Erfindung sind zwischen den Einzelzellen einer Zellreihe Zellverbinder vorgesehen und ein an einer Stelle einer Zellreihe zwischen den Einzelzellen liegender Zellverbinder über eine Ausgleichsleitung mit dem an einer gleichen Stelle der parallelen Zellreihe liegenden Zellverbinder elektrisch verbunden. Das Potenzial des mit der Ausgleichsleitung verbundenen Zellverbinders an der einen Stelle der einen Zellreihe wird als erste Messgröße erfasst. Das Potenzial des mit der Ausgleichsleitung elektrisch verbundenen Zellverbinders an der gleichen Stelle der parallelen Zellreihe wird ebenfalls als Messgröße erfasst. Die erfassten Potenziale werden einer Auswerteeinheit zugeführt. Insbesondere werden die erfassten Potenziale untereinander ausgewertet, wobei das Auswertungsergebnis eine Aussage über eine defekte Zelle an der Stelle der Zellreihe zulässt. Abhängig von der Auswertung wird ein Signal generiert, das zur Steuerung der Schalter im Akkupack genutzt werden kann.

In einfacher Weise werden die erfassten Potenziale der an gleicher Stelle in den parallelen Zellreihen liegenden Zellverbinder unmittelbar miteinander verglichen und vorteilhaft durch Subtraktion eine Differenzspannung abgeleitet, deren Größe unmittelbar zur Ansteuerung der Schalter im Akkupack herangezogen werden kann. Überschreitet die Differenzspannung einen Schwellwert, wird ein Signal zum Abschalten des Akkupacks ausgegeben.

Vorteilhaft sind die Zellreihen in einem Gehäuse des Akkupacks angeordnet, wobei im Gehäuse eine Auswerteeinheit vorgesehen ist, der die Potenziale der mit Ausgleichsleitungen verbundenen Zellverbinder der einen Zellreihe und die erfassten Potenziale der zugeordneten Zellverbinder einer parallelen Zellreihe zugeführt sind. Die Auswerteeinheit kann als Mikroprozessor ausgestaltet sein und über einen entsprechenden Algorithmus die Auswertung der jeweils erfassten Potenziale vornehmen.

Vorteilhaft weist ein Akkublock mehr als zwei Zellreihen auf, die zueinander elektrisch parallel liegen. Alle an gleicher Stelle der parallelen Zellreihe liegenden Zellverbinder sind vorteilhaft über Ausgleichsleitungen miteinander elektrisch verbunden. Innerhalb einer derartigen Parallelschaltung aus mehreren Zellreihen werden die Potenziale der Zellverbinder der letzten Zellreihe der Parallelschaltung und der ersten Zellreihe der Parallelschaltung erfasst und ausgewertet. Die Zellreihen sind zweckmäßig die äußeren Zellreihen der Parallelschaltung.

Eine weitere, eigenständige Erfindung ist dadurch gebildet, dass die parallelen Zellreihen der Einzelzellen eine gedachte Matrix aus m-Zeilen von Einzelzellen und n-Spalten aus Zellreihen bilden. Durch Vergleich der Potenziale der Zellverbinder kann die Zeile eines Defektes ermittelt werden und durch eine Plausibilitätsprüfung der Strangströme der Zellreihen die Spalte des Defektes ermittelt werden. Auf diese Weise ist eine Lokalisierung des Defektes innerhalb der Anordnung aus Einzelzellen möglich. Dabei kann gezielt eine nach dem Prinzip der Matrix festgestellte defekte Zellreihe durch den Schalter der Zellreihe abgeschaltet werden.

Vorteilhaft kann auch das von der Auswerteeinheit generierte Signal als Steuersignal zum Abschalten des gesamten Akkupacks durch einen oder mehrere Schalter herangezogen werden.

Weitere Merkmale der Erfindung ergeben sich aus den weiteren Ansprüchen, der Beschreibung und der Zeichnung, in der ein nachfolgend im Einzelnen beschriebenes Ausführungsbeispiel der Erfindung dargestellt ist. Es zeigen:

Fig. 1    in schematischer Darstellung ein elektrisches Ersatzschaltbild eines Akkupacks,

Fig. 2    in schematischer Darstellung einen Zellblock des Akkupacks nach Fig. 1,

Fig. 3    ein Diagramm zur Auswertung der erfassten Potenziale,

Fig. 4    in schematischer Darstellung ein elektrisches Teilersatzschaltbild eines Akkupacks mit Plausibilitätskontrolle der fließenden Ströme,

Fig. 5     ein Ablaufdiagramm für eine Plausibilitätskontrolle.

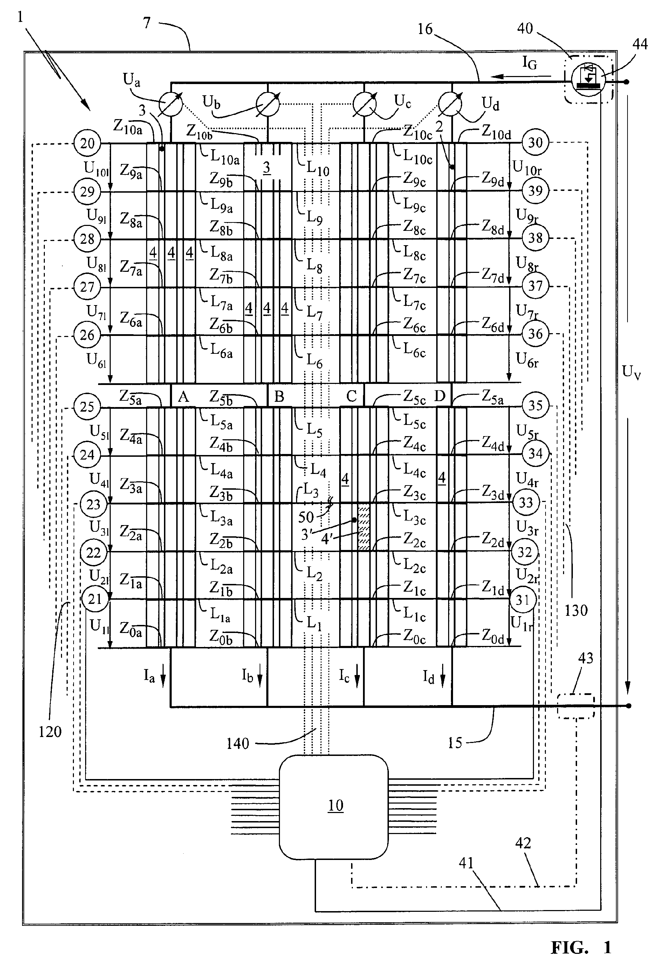

In Fig. 1 ist ein Akkupack 1 gezeigt, der aus einer Vielzahl von Zellblöcken 2, 3 aufgebaut ist. Im gezeigten Ausführungsbeispiel ist eine gleiche Anzahl von Zellblöcken 2 bzw. 3 zu jeweils einer Zellreihe A, B, C bzw. D hintereinander geschaltet. Die Zellreihen A, B, C und D liegen zueinander parallel und sind mit ihren Enden mit den Anschlusspolen 15 bzw. 16 des Akkupacks 1 verbunden. Zwischen den Anschlusspolen 15, 16 liegt die äußere Versorgungsspannung Uv.

Im Ausführungsbeispiel besteht eine Zellreihe A, B, C bzw. D aus je zehn Zellblöcken 2 bzw. 3, die in einer Reihe hintereinander geschaltet sind.

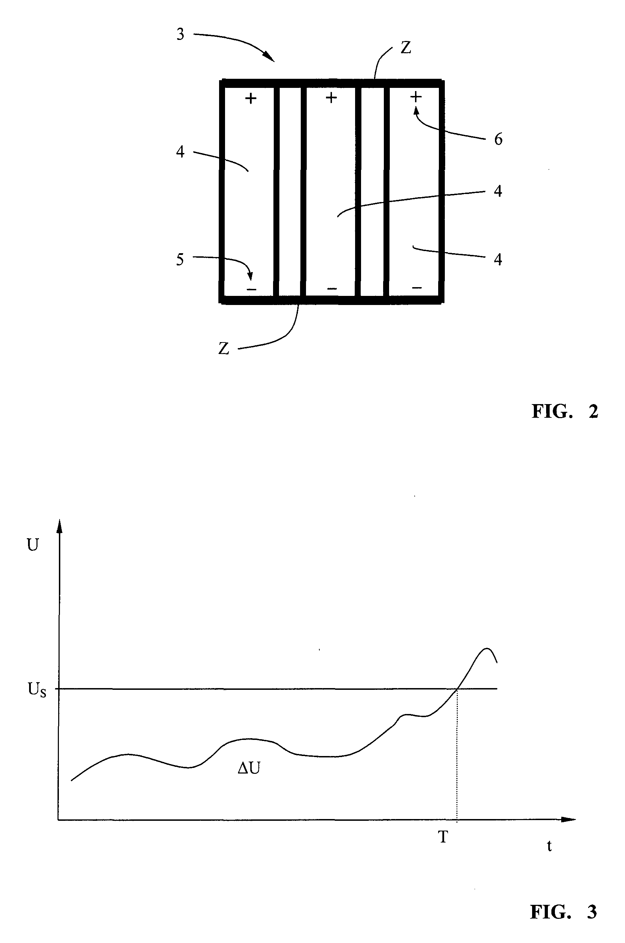

In Fig. 2 ist beispielhaft ein Zellblock 3 wiedergegeben. Im gezeigten Ausführungsbeispiel besteht der Zellblock 3 aus drei Einzelzellen 4, die elektrisch in Parallelschaltung geschaltet sind und deren Anschlüsse mit je einem Zellverbinder Z verbunden sind, der einen jeweiligen Anschlusspol 5, 6 des Zellblocks 3 bildet.

Wie Fig. 1 zeigt, sind die Zellblöcke 2 aus zwei in Parallelschaltung liegenden Einzelzellen 4 gebildet; ein Zellblock kann auch aus nur einer einzigen Einzelzelle 4 gebildet sein. Zweckmäßig besteht ein Zellblock 2, 3 aus mehreren Einzelzellen, die elektrisch in Parallelschaltung und/oder in Reihenschaltung verschaltet sind.

Der im Ausführungsbeispiel aus vier parallelen Zellreihen A, B, C, D bestehende Akkupack 1 ist mit einer Vielzahl von Ausgleichsleitungen versehen, die allgemein mit $L_{na}$, $L_{nb}$, $L_{nc}$ bezeichnet sind, wobei n die Zahl "0" bis "10" ($0 \leq n \leq 10$) einnehmen kann. Die Ausgleichsleitungen $L_{na}$, $L_{nb}$, $L_{nc}$ sind als elektrische Querverbindungen zwischen den Zellreihen A, B, C und D vorgesehen. Allein für die Plausibilitätsprüfung sind die Ausgleichsleitungen $L_{na}$, $L_{nb}$, $L_{nc}$ nicht zwingend erforderlich.

Zwischen den Einzelzellen 4 bzw. Zellblöcken 2 bzw. 3 einer Reihe A, B, C, D liegen Zellverbinder. Wie in Fig. 1 dargestellt, weist die Zellreihe A die Zellverbinder $Z_{0a}$, $Z_{1a}$, $Z_{2a}$, $Z_{3a}$, $Z_{4a}$, $Z_{5a}$, $Z_{6a}$, $Z_{7a}$, $Z_{8a}$, $Z_{9a}$, $Z_{10a}$, auf, die im Folgenden auch als Zellverbinder $Z_{na}$ ($0 \leq n \leq 10$) bezeichnet sind. Entsprechend weist die Zellreihe B zwischen den Zellblöcken 3 Zellverbinder $Z_{nb}$, also die Zellverbinder $Z_{0b}$, $Z_{1b}$, $Z_{2b}$, $Z_{3b}$, $Z_{4b}$, $Z_{5b}$, $Z_{6b}$, $Z_{7b}$, $Z_{8b}$, $Z_{9b}$, $Z_{10b}$ auf, die allgemein mit $Z_{nb}$ ($0 \leq n \leq 10$) bezeichnet sind. Die Zellverbinder zwischen den Zellblöcken 3 der Zellreihe C sind mit $Z_{nc}$, also $Z_{0c}$, $Z_{1c}$, $Z_{2c}$, $Z_{3c}$, $Z_{4c}$, $Z_{5c}$, $Z_{6c}$, $Z_{7c}$, $Z_{8c}$, $Z_{9c}$, $Z_{10c}$ bezeichnet und allgemein mit $Z_{nd}$ ($0 \leq n \leq 10$) benannt. Die Zellverbinder der Zellreihe D sind mit dem Bezugszeichen $Z_{nd}$ ($0 \leq n \leq 10$), d. h., $Z_{0d}$, $Z_{1d}$, $Z_{2d}$, $Z_{3d}$, $Z_{4d}$, $Z_{5d}$, $Z_{6d}$, $Z_{7d}$, $Z_{8d}$, $Z_{9d}$, $Z_{10d}$ bezeichnet.

Der Zellverbinder $Z_{1a}$ liegt in der Zellreihe A an der gleichen ersten Stelle wie der Zellverbinder $Z_{1b}$ in der Zellreihe B, der Zellverbinder $Z_{1c}$ in der Zellreihe C und der Zellverbinder $Z_{1d}$ in der Zellreihe D. Entsprechend liegt somit jeder Zellverbinder $Z_{na}$ der Zellreihe A an gleicher n-ter Stelle wie der Zellverbinder $Z_{nb}$ in der Zellreihe B, der Zellverbinder $Z_{nc}$ in der Zellreihe C oder der Zellverbinder $Z_{nd}$ in der Zellreihe D.

Die Ausgleichsleitungen $L_{na}$, $L_{nb}$ und $L_{nc}$ verbinden jeweils die an gleicher n-ter Stelle in einer Zellreihe liegenden Zellverbinder $Z_{na}$, $Z_{nb}$, $Z_{nc}$ und $Z_{nd}$ der Zellreihen A, B, C und D miteinander. So ist der an sechster Stelle der Zellreihe liegende Zellverbinder $Z_{6a}$ über die Ausgleichsleitung $L_{6a}$ mit dem an sechster Stelle in der Zellreihe B liegenden Zellverbinder $Z_{6b}$ verbunden, der seinerseits über die Ausgleichsleitung $L_{6b}$ mit dem an sechster Stelle der Zellreihe C liegenden Zellverbinder $Z_{6c}$ der Zellreihe C verbunden ist. Der Zellverbinder $Z_{6c}$ ist ferner über die Ausgleichsleitung $L_{6c}$ mit dem an sechster Stelle der Zellreihe D liegenden Zellverbinder $Z_{6d}$ verbunden. Bezogen auf das in Fig. 1 dargestellte schematische Schaltbild sind die an einer n-Stelle in einer Zellreihe A, B, C, D liegenden Zellverbinder jeweils über Ausgleichsleitungen $L_{na}$, $L_{ab}$, $L_{nc}$ mit den an gleicher n-ter Stelle liegenden Zellverbindern benachbarter Reihen verbunden. So steht der Zellverbinder $Z_{7c}$ mit den an gleicher Stelle liegenden Zellverbindern $Z_{7b}$ und $Z_{7d}$ der benachbarten Zellreihen B und D über die Ausgleichsleitungen $L_{7b}$ und $L_{7c}$ in Verbindung. Entsprechend steht z. B. der Zellverbinder $Z_{2b}$ der Zellreihe B über die Ausgleichsleitungen $L_{2a}$ und $L_{2b}$ mit den an gleicher Stelle der Zellreihen A und C liegenden benachbarten Zellverbindern $Z_{2a}$ und $Z_{2c}$ in Verbindung. Allgemein ausgedrückt steht ein an einer n-ten Stelle einer Zellreihe A, B, C oder D zwischen den Zellblöcken 2 bzw. 3 liegender Zellverbinder $Z_{na}$, $Z_{nb}$, $Z_{nc}$, $Z_{nd}$ über eine Ausgleichsleitung $L_{na}$, $L_{nb}$, $L_{nc}$ mit den an einer gleichen n-ten Stelle der parallelen Zellreihe A, B, C bzw. D liegenden Zellverbindern $Z_{na}$, $Z_{nb}$, $Z_{nc}$, $Z_{nd}$ elektrisch in Verbindung.

Die in Fig. 1 dargestellte Parallelschaltung eines Akkupacks 1 hat äußere Zellreihen A und D sowie innere Zellreihen B und C. Die Zellverbinder $Z_{nb}$ und $Z_{nc}$ der inneren Zellreihen B und C stehen jeweils mit den auf beiden Seiten einer Zellreihe liegenden Zellverbindern benachbarter Zellreihen elektrisch in Verbindung.

Die in den Zellreihen A, B, C, D bei einer Belastung (Entladung und Ladung des Zellverbundes 5) fließenden Ströme $I_a$, $I_b$, $I_c$, $I_d$ werden z. B. über Shunt-Widerstände erfasst, an denen die Spannungen $U_a$, $U_b$, $U_c$ und $U_d$ abfallen. Somit kann über den Spannungsabfall $U_a$, $U_b$, $U_c$ und $U_d$ der jeweilige Strom $I_a$, $I_b$, $I_c$ und $I_d$ in den Zellreihen A, B, C, D erfasst werden. Die Spannungen $U_a$, $U_b$, $U_c$ und $U_d$ werden über Signalleitungen 140 einer Auswerteeinheit 10 zugeführt, die die abgegriffenen Spannungen $U_a$, $U_b$, $U_c$ und $U_d$, und damit die Strangströme $I_a$, $I_b$, $I_c$ und $I_d$ vergleicht und bei nicht plausibler Abweichung der Strangströme $I_a$, $I_b$, $I_c$, $I_d$ voneinander ein Signal generiert.

Da die Zellreihen A, B und C gleich ausgebildet sind und zueinander parallel liegen, muss in jeder Zellreihe A, B, C zu jedem Zeitpunkt ein gleicher Strom $I_a$, $I_b$, $I_c$ fließen. Die Ströme $I_a$, $I_b$, $I_c$ sollten daher zu jedem Zeitpunkt in etwa gleich sein; die Auswerteeinheit 10 überprüft somit, ob die Spannungen $U_a$, $U_b$ und $U_c$ in einem Zeitpunkt $t_1$ etwa gleich sind. Bei diesem Plausibilitätsvergleich werden leichte Abweichungen in der Größe der Spannung $U_a$, $U_b$, $U_c$ ignoriert; nur wenn die Spannungen $U_a$, $U_b$, $U_c$ signifikant voneinander abweichen, muss ein Fehler in einer der Zellreihen vorliegen, da aufgrund des gleichen konstruktiven Aufbaus der Zellreihen nur gleiche Stromwerte plausibel sind. Auf diese Weise kann der Vergleich auf Plausibilität ausgewertet werden, um in Abhängigkeit des Ergebnisses der Plausibilität ein Signal zu generieren, welches als Steuersignal zum Abschalten des Akkupacks über einen Schalter 40 bzw. 43 genutzt werden kann, der über Steuerleitungen 41, 42 von der Auswerteeinheit 10 angesteuert wird.

Ein äußerer Laststrom $I_G$ teilt sich in die Strangströme $I_a$, $I_b$, $I_c$, $I_d$ auf, wobei der Strom $I_d$ der Zellreihe D kleiner ist als der in den anderen Zellreihen A, B und C, da die Zellreihe D aus Zellblöcken 2 besteht, die nur zwei Einzelzellen 4 in Parallelschaltung aufweisen. Die Auswerteeinheit 10 kann somit überprüfen, ob die abgegriffene Spannung $U_d$ in dem entsprechenden Maß kleiner ist wie die Spannungen $U_a$, $U_b$, $U_c$ der parallelen Zellreihen A, B, C. Wird z. B. der Strom $I_d$ in der Zellreihe D aufgrund eines Umladeeffektes zwischen den Zellreihen größer, so wächst die Spannung $U_d$ an, was von der Auswerteeinheit 10 registriert wird. Die Plausibilität der erfassten Spannungen $U_a$, $U_b$, $U_c$ und $U_d$ untereinander ist nicht mehr gegeben; es wird ein Signal erzeugt, welches zum Ausschalten des Akkupacks genutzt werden kann.

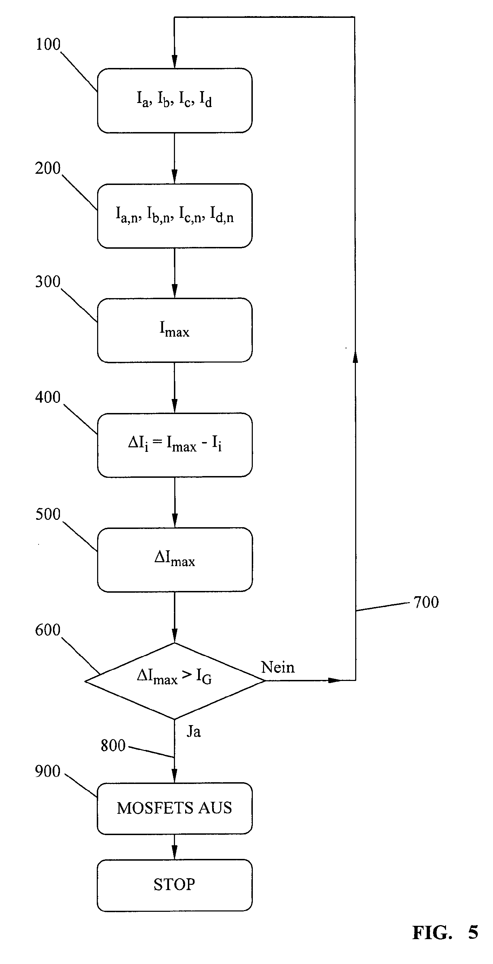

Der direkte Vergleich der erfassten Spannungen $U_a$, $U_b$, $U_c$ und $U_d$ gibt im Ausführungsbeispiel das Verhältnis der Strangströme $I_a$, $I_b$, $I_c$, $I_d$ oder der normierten Strangströme $I_{a,n}$, $I_{b,n}$, $I_{c,n}$, $I_{d,n}$ (Fig. 5) untereinander wieder; es kann aber auch ein rechnerisches Verhältnis V der Strangströme $I_a$, $I_b$, $I_c$, $I_d$ oder der normierten Strangströme $I_{a,n}$, $I_{b,n}$, $I_{c,n}$, $I_{d,n}$ (Fig. 5) zueinander betrachtet werden. Aus dem gebildeten Verhältnis V der Strangströme $I_a$, $I_b$, $I_c$, $I_d$ oder der normierten Strangströme $I_{a,n}$, $I_{b,n}$, $I_{c,n}$, $I_{d,n}$ (Fig. 5) kann unmittelbar auf die Plausibilität der Strangströme $I_a$, $I_b$, $I_c$, $I_d$ geschlossen werden. Ein zulässiges, plausibles Verhältnis V liegt z. B. bei "Eins", sofern die Strangströme $I_a$, $I_b$, $I_c$ oder der normierten Strangströme $I_{a,n}$, $I_{b,n}$, $I_{c,n}$ (Fig. 5) in den gleich aufgebauten Zellreihen miteinander verglichen werden. Weicht das errechnete Verhältnis V signifikant von dem vorgegebenen plausiblen Verhältnis ab, ist die geforderte Plausibilität nicht mehr gegeben und es wird ein Signal generiert, welches z. B. zum Abschalten des Akkupacks verwendet werden kann.

Unter dem Bilden eines Verhältnisses wird auch die Bildung eines Differenzsignals zwischen zwei Strangströmen verstanden; für ein zulässiges Differenzsignal wird ein Grenzwert vorgegeben, welcher nicht überschritten werden darf. Bei gleich ausgebildeten Zellreihen wird der Grenzwert zu "Null" festgesetzt; weicht das Differenzsignal vom Grenzwert signifikant ab, ist das Differenzsignal also größer oder kleiner als der ein Verhältnis wiedergebende Grenzwert, ist die Plausibilität der Strangströme nicht mehr gegeben und es wird ein Signal generiert.

Ein Plausibilitätsvergleich ist in einfacher Weise auch durch Überwachung des Vorzeichens eines Strangstroms auf einen Vorzeichenwechsel möglich; auch der Vorzeichenwechsel kann z. B. durch Verhältnisbildung des Strangstroms in einer Zellreihe zu einem ersten Zeitpunkt mit dem in der gleichen Zellreihe fließenden Strangstrom zu einem zweiten Zeitpunkt ermittelt werden. Wechselt das Vorzeichen eines Strangstroms in der gleichen Zellreihe, liegt eine nicht plausible Abweichung vor; es wird ein Signal generiert, welches zur Abschaltung des Akkupacks herangezogen werden kann.

Der Vorzeichenwechsel eines Strangstroms in parallelen Zellreihen kann auch in einfacher Weise dadurch überwacht werden, dass die in einem gleichen Zeitpunkt fließenden Strangströme der Zellreihen zueinander ins Verhältnis gesetzt werden; wird das Verhältnis negativ, hat ein Strangstrom das Vorzeichen gewechselt, was als nicht plausibel eingestuft wird. Es wird ein Signal generiert, welches zum Abschalten des Akkupacks verwendet werden kann.

Für einen Plausibilitätsvergleich sind keine absoluten Messwerte notwendig; aufwendige Algorithmen und Berechnungen zur Ableitung einer Information aus einem absoluten Messwert sind entbehrlich. Da keine absoluten Werte notwendig sind, werden die erfassten Strangströme $I_a$, $I_b$, $I_c$, $I_d$ bzw. die zu den Strangströmen proportionalen Spannungen $U_a$, $U_b$, $U_c$, $U_d$ durch Normierung mit der Anzahl der in einer Zellreihe parallel liegenden Einzelzellen normiert. Allein aus der relativen Größe der normierten Messwerte relativ zu anderen normierten Messwerten kann eine nicht plausible Abweichung festgestellt werden.

So werden die in der Zellreihe A erfassten Messwerte mit der Anzahl der in der Zellreihe A parallel liegenden Einzelzellen 4 normiert, also durch "Drei" geteilt; entsprechend werden die in der Zellreihe D erfassten Messwerte mit der Anzahl der in der Zellreihe D parallel liegenden Einzelzellen 4 normiert, also durch "Zwei" geteilt.

Neben der Plausibilitätskontrolle der in den Zellreihen A, B, C und D fließenden Ströme $I_a$, $I_b$, $I_c$, $I_d$ kann zusätzlich eine Spannungsüberwachung an Potenzialpunkten 20 bis 29 bzw. 30 bis 39 der Parallelschaltung vorgesehen sein.

Die Zellverbinder $Z_{na}$ und $Z_{nd}$ der äußeren Zellreihen A und D bilden Potenzialpunke 20 bis 29 bzw. 30 bis 39, wobei die zwischen den Potenzialpunkten liegende Spannung $U_{1r}$, $U_{2r}$, $U_{3r}$, $U_{4r}$, $U_{5r}$, $U_{6r}$, $U_{7r}$, $U_{8r}$, $U_{9r}$, $U_{10r}$ ($U_{nr}$ $1 \leq n \leq 10$) bzw. $U_{1L}$, $U_{2L}$, $U_{3L}$, $U_{4L}$, $U_{5L}$, $U_{6L}$, $U_{7L}$, $U_{8L}$, $U_{9L}$, $U_{10L}$ ($U_{nL}$ $1 \leq n \leq 10$) abgegriffen wird. So werden die Potenziale der Potenzialpunkte 20 bis 29 auf der linken Seite des Akkupacks, also die Potenzialpunkte 20 bis 29 der Zellreihe A, über Signalleitungen 120 einer Auswerteeinheit 10 zugeführt. Entsprechend werden die Potenziale der Potenzialpunkte 30 bis 39 auf der rechten Seite der Parallelschaltung, also die Potenzialpunkte 30 bis 39 der äußeren Zellreihe D, über Signalleitungen 130 der Auswerteeinheit 10 zugeführt.

Sind die Einzelzellen 4 paralleler Zellreihen A, B, C, D etwa gleich stark und in der gleichen Kondition, werden bei Last wie im Ruhezustand über die Ausgleichsleitungen $L_{na}$, $L_{nb}$, $L_{nc}$ keine nennenswerten Ströme fließen. Daher wird das Potenzial des Zellverbinders an der Stelle "2" in der einen Zellreihe das gleiche sein wie das Potenzial des an gleicher Stelle "2" liegenden Zellverbinders der parallelen Zellreihe, die über die Ausgleichsleitung miteinander verbunden sind. Altern die Zellen unterschiedlich stark und brechen z. B. unter Last stärker ein als andere Einzelzellen 4 einer Zellreihe A, B, C, D, wird über eine Ausgleichsleitung $L_{na}$, $L_{nb}$, $L_{nc}$ ein Ausgleichsstrom fließen, um die schwächere Einzelzelle zu stützen. Aufgrund des Ausgleichsstroms in der Ausgleichsleitung $L_{na}$, $L_{nb}$, $L_{nc}$ und der dadurch an ihrem ohmschen Widerstand abfallenden Spannung werden sich die Potenziale der miteinander verbundenen Zellverbinder unterschiedlich verändern. Der Potenzialunterschied zwischen den beiden Zellverbindern an der gleichen Stelle in parallelen Zellreihen ist somit ein Maß für den Ausgleichsstrom und somit ein Indikator für eine defekte Einzelzelle.

Innerhalb der Auswerteeinheit 10 werden die erfassten Spannungen $U_{nr}$, $U_{nl}$ bzw. die erfassten Potenziale ausgewertet; die Auswerteeinheit ist vorteilhaft als Mikroprozessor ausgestaltet und wertet über einen entsprechenden Algorithmus das jeweils erfasste Potenzial aus. Abhängig vom Ergebnis der Auswertung wird ein Signal generiert, das vorzugsweise als Steuersignal über eine Steuerleitung 41 einem Schalter 40 zugeführt ist, der im dargestellten Ausführungsbeispiel im Plus-Anschlusspol 16 des Akkupacks 1 vorgesehen ist. Ergänzend oder alternativ kann auch im Minus-Anschlusspol 15 ein Schalter 43 vorgesehen sein, der über die Steuerleitung 42 von der Auswerteeinheit 10 angesteuert ist. Die Ausschalter 40 und 43 sind im Gehäuse 7 des Akkupacks 1 angeordnet und dienen dem Abschalten des gesamten Akkupacks 1, wenn die Auswerteeinheit 10 aufgrund von Abweichungen der erfassten Potenziale $U_{nr}$ und $U_{nl}$ ein Signal generiert und über die Steuerleitung 41 bzw. 42 ausgibt.

Bevorzugt ist der Schalter 40 bzw. 43 als elektronischer Schalter 44 vorgesehen, insbesondere als MOSFET ausgebildet.

Im Betrieb des Akkupacks können über die Ausgleichsleitungen $L_{na}$, $L_{nb}$, $L_{nc}$ Ausgleichsströme fließen, um ungleiche Ladungsmengen in den Einzelzellen 4 auszugleichen. Diese Ausgleichsleitungen $L_{na}$, $L_{nb}$, $L_{nc}$ sind derart ausgelegt, dass sie die im Normalbetrieb auftretenden Ausgleichsströme sicher führen können.

Die Ausgleichsleitungen $L_{na}$, $L_{nb}$ und $L_{nc}$ sind vorteilhaft derart gestaltet, dass sie zugleich als Sicherungen zwischen den Zellreihen bzw. den Zellblöcken dienen. Liegen die Ausgleichsströme im normalen Betrieb innerhalb der zulässigen Grenzen, erfolgt eine derartige Ladungsverteilung zwischen den Zellblöcken, dass in diesen im Wesentlichen eine etwa gleiche Ladung gespeichert ist. Daher werden die Potenziale an den Potenzialpunkten 20 bis 29 jeweils den entsprechenden Potenzialen an den Potenzialpunkten 30 bis 39 entsprechen. Die Auswerteeinheit 10 wird somit auf der linken Seite der Parallelschaltung an den Potenzialpunkten 20 bis 29 Spannungen $U_{nl}$ erfassen, die etwa den Spannungen $U_{nr}$ entsprechen, die sich zwischen den Potenzialpunkten 30 bis 39 auf der rechten Seite der Parallelschaltung ermitteln lassen. Ist z. B. die Spannung $U_{4r}$ etwa so groß wie die Spannung $U_{4l}$, kann davon ausgegangen werden, dass die in der Zellreihe A, B, C, D an vierter Stelle liegenden Zellblöcke $Z_{4a}$, $Z_{4b}$, $Z_{4c}$ und $Z_{4d}$ ordnungsgemäß arbeiten.

Tritt hingegen in nur einer Einzelzelle 4' ein Defekt auf, z. B. im dritten Zellblock 3' der Zellreihe C, so werden über die Ausgleichsleitungen $L_{2b}$ bzw. $L_{2c}$ und $L_{3b}$ bzw. $L_{3c}$ erhöhte Ausgleichsströme fließen. Da die Ausgleichsleitungen vorteilhaft zugleich als Sicherungen ausgebildet sind, wird bei einem zu hohen Strom z. B. die Ausgleichsleitung $L_{3b}$ schmelzen. So ist in Fig. 3 eine Unterbrechung 50 der Ausgleichsleitung $L_{3b}$ angenommen. Aufgrund des nun fehlenden Ausgleichsstroms über die Ausgleichsleitung $L_{3b}$ wird sich der Ladezustand des dritten Zellblocks 3' rascher ändern als die der übrigen Zellblöcke 2, 3. Dadurch aber ändert sich das Potenzial im Potenzialpunkt 33 auf der rechten Seite der Parallelschaltung in Bezug zum Potenzial des Potenzialpunktes 23 auf der linken Seite der Parallelschaltung. Die Auswerteeinheit 10 kann aufgrund der über die Signalleitungen 120, 130 zugeführten Potenziale der jeweiligen Potenzialpunkte 20 bis 29 bzw. 30 bis 39 erkennen, dass die zwischen den Potenzialpunkten 32 und 33 liegende Spannung $U_{3r}$ von der auf der anderen Seite der Parallelschaltung zwischen den Potenzialpunkten 23 und 22 gemessenen Spannung $U_{3l}$ abweicht. Aufgrund der Abweichung wird ein Signal generiert, das als Steuersignal die Schalter 40 bzw. 43 im Akkupack betätigt. Der Akkupack 1 wird abgeschaltet. Eine weitere Schädigung der Einzelzellen ist vermieden.

In einfacher Weise werden die erfassten Potenziale $U_{nr}$ und $U_{nl}$ der an gleicher n-ter Stelle liegenden Zellverbinder direkt miteinander verglichen und eine Differenzspannung $\Delta U$ gebildet, die permanent mit einem Schwellwert $U_s$ verglichen wird (Fig. 3). Überschreitet die Differenzspannung $\Delta U$ den Schwellwert $U_s$ zum Zeitpunkt T, wird ein Signal generiert, welches z. B. zum Abschalten des Akkupacks führt. Die in Fig. 3 dargestellten Schwankungen der Differenzspannung $\Delta U$ sind auf im Betrieb fließende Ausgleichsströme in den Ausgleichsleitungen zurückzuführen; erst wenn die Ausgleichsströme zu groß werden oder eine Ausgleichsleitung entsprechend ihrem Charakter als Sicherung unterbrochen wird, wächst die Differenzspannung $\Delta U$ über den Schwellwert $U_s$ an und führt zu einem Abschalten des Akkupacks 1.

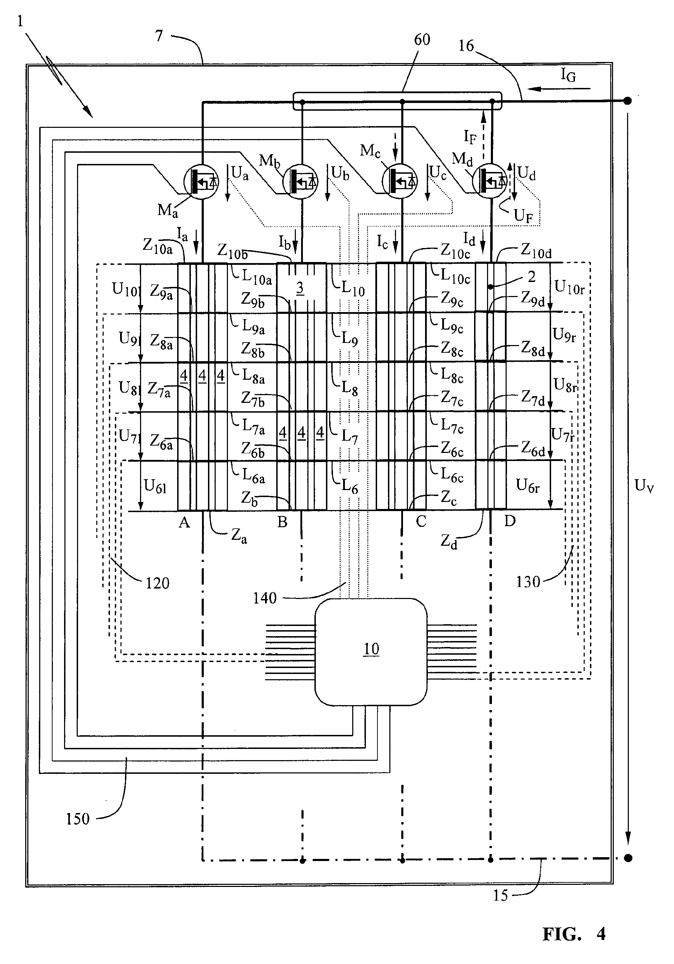

Als weitere, selbstständige Erfindung kann vorgesehen sein, durch die parallelen Zellreihen A, B, C und D der Einzelzellen 4 eine gedachte Matrix aus zehn Zeilen (allgemein: m-Zeilen) von Einzelzellen und vier Spalten (allgemein: n-Spalten) aus Zellreihen A, B, C und D zu bilden. Durch die Spannungsüberwachung an den Potenzialpunkten 30 bis 39 und 20 bis 29 einerseits und die Plausibilitätskontrolle der in den Zellreihen A, B, C und D fließenden Zellströme $I_a$, $I_b$, $I_c$, $I_d$ kann der Zellblock 2, 3 aus Einzelzellen 4 festgestellt werden, der einen Defekt aufweist. Durch den Vergleich der Potenziale der Zellverbinder $Z_{na}$, $Z_{nd}$ kann die Zeile des Defektes ermittelt und durch die Plausibilitätsprüfung der Strangströme $I_a$, $I_b$, $I_c$ und $I_d$ die Spalte A, B, C, D des Defektes ermittelt werden. Wird - wie in Fig. 4 dargestellt - in jeder Zellreihe A, B, C, D ein Schalter vorgesehen, der im Ausführungsbeispiel nach Fig. 4 als elektronischer Schalter $M_a$, $M_b$, $M_c$, $M_d$, insbesondere als MOSFET ausgebildet ist, kann entsprechend die nach dem Prinzip der Matrix festgestellte defekte Zellreihe A, B, C, D durch den entsprechenden Schalter $M_a$, $M_b$, $M_c$, $M_d$ abgeschaltet werden. Zweckmäßig erfolgt jedoch ein Abschalten des gesamten Akkupacks durch die im Gehäuse des Akkupacks 1 angeordneten Schalter 40 bzw. 43. Es kann auch vorgesehen sein, bei Auftreten eines Defektes anstelle der in den Anschlusspolen liegenden Schalter 40 und 43 zeitgleich alle in den Zellreihen liegenden elektronischen Schalter $M_a$, $M_b$, $M_c$, $M_d$ über die Steuerleitungen 150 auszuschalten.

Wie in Fig. 4 angedeutet, können die in den Zellreihen A, B, C und D fließenden Ströme $I_a$, $I_b$, $I_c$, $I_d$ auch mit einem Gesamtstrom $I_G$ verglichen werden, der am Anschlusspol 15 bzw. 16 des Akkupacks 1 erfasst wird. Dabei werden die Beträge der in den Strängen zum oder vom Knoten 60 fließenden Ströme $I_a$, $I_b$, $I_c$, $I_d$ einerseits addiert und mit dem im Anschlusspol 16 zum Knoten 60 fließenden Strom $I_G$ andererseits, der auch als Betrag angesetzt werden kann, verglichen. Vorteilhaft gilt:

$$|I_G| = |I_a| + |I_b| + |I_c| + |I_d| \,.$$

Die Plausibilität ist nur gegeben, wenn der gebildete Summenstrom $|I_a| + |I_b| + |I_c| + |I_d|$ dem Gesamtstrom $I_G$ oder $|I_G|$ entspricht. Ist der Gesamtstrom "Null" und wird dennoch ein Summenstrom ermittelt, ist das Ergebnis nicht plausibel; es wird ein entsprechendes Signal generiert. Über die Plausibilitätsprüfung z. B. in der Auswerteeinheit 10 kann somit jederzeit festgestellt werden, ob der Akkupack noch in Ordnung ist.

Ergeben sich aufgrund eines Defektes in einer Zellreihe, z. B. in der Zellreihe C, Ausgleichsströme, so kann z. B. aus der Zellreihe D ein Fehlstrom $I_F$ in die Zellreihe D abfließen; damit verändert sich der Summenstrom der einzelnen Beträge der Ströme $|I_a| + |I_b| + |I_c| + |I_d|$ relativ zum Betrag des Gesamtstroms $I_G$, was durch die Plausibilitätsprüfung als Defekt erkannt wird.

In einfacher Weise können die Strangströme $I_a$, $I_b$, $I_c$, $I_d$ in den Zellreihen A, B, C, D durch die an den elektronischen Schaltern $M_a$, $M_b$, $M_c$, $M_d$ abfallenden Spannung $U_a$, $U_b$, $U_c$, $U_d$ erfasst werden, so dass Shunt-Widerstände nicht notwendig sind. Die am elektronischen Schalter abfallende Spannung $U_a$, $U_b$, $U_c$, $U_d$ ist eine proportionale Größe zu einem fließenden Strangstrom $I_a$, $I_b$, $I_c$, $I_d$. Liegt ein erheblicher Defekt vor, kann z. B. die an einem Schalter $M_a$, $M_b$, $M_c$, $M_d$ abfallende Spannung sich umkehren, wie in Fig. 4 am Beispiel der Zellreihe D mit der Spannung $U_F$ strichliert dargestellt ist.

Im Ausführungsbeispiel basieren die Einzelzellen 4 chemisch auf Lithium; vorteilhaft sind die Einzelzellen 4 LiIon-Zellen, Li-Polymerzellen, LiFE-Zellen oder dergleichen Zellen. Die Einzelzellen 4 können auch einen anderen chemischen Aufbau haben, z. B. NiCd, NiMh oder dgl..

In einer weiteren Ausführungsform der Plausibilitätsprüfung wird nach dem zeitlich immer wieder durchlaufenden Ablaufdiagramm in Fig. 5 aus allen erfassten Strangströmen $I_a$, $I_b$, $I_c$, $I_d$, insbesondere den normierten Strangströmen $I_{a,n}$, $I_{b,n}$, $I_{c,n}$, $I_{d,n}$, ein maximaler Strangstrom $I_{max}$ festgestellt und für eine weitere Auswertung herangezogen. Im Ablaufdiagramm ist mit 100 der Schritt der Erfassung der Strangströme $I_a$, $I_b$, $I_c$, $I_d$ zu einem Zeitpunkt $t_1$ bezeichnet und mit 200 der Schritt der Normierung auf die Anzahl n der in einer Zellreihe in einem Zellblock parallel geschalteten Einzelzellen 4. Im Schritt 300 wird aus den normierten Strangströmen $I_{a,n}$, $I_{b,n}$, $I_{c,n}$, $I_{d,n}$ ein maximaler Strangstrom $I_{max}$ ausgewählt und im folgenden Schritt 400 jeweils ein Differenzstrom $\Delta I_i$ zwischen dem maximalen Strangstrom $I_{max}$ und jedem der anderen Strangströme $I_i$ ermittelt. Wird also der normierte Strangstrom $I_{c,n}$, als maximaler Strangstrom $I_{max}$ festgestellt ($I_{max} = I_{c,n}$), wird der jeweilige Differenzstrom $\Delta I_i$ wie folgt ermittelt:

$$\Delta I_1 = I_{max} - I_1 \ (\text{mit } I_1 = I_{a,n})$$

$$\Delta I_2 = I_{max} - I_2 \ (\text{mit } I_2 = I_{b,n})$$

$$\Delta I_3 = I_{max} - I_3 \ (\text{mit } I_3 = I_{d,n})$$

Aus den ermittelten Differenzströmen $\Delta I_1$, $\Delta I_2$, $\Delta I_3$ wird im Schritt 500 der maximale Differenzstrom $\Delta I_{max}$ ausgewählt und im folgenden Schritt der Entscheidungsraute 600 mit einem vorgegebenen, zulässigen Grenzwert $I_G$ verglichen. Liegt der Differenzstrom $\Delta I_{max}$ unterhalb des zulässigen Grenzwerts $I_G$, geht es über den Zweig 700 der Entscheidungsraute 600 zurück zu Schritt 100, um in einem folgenden Zeitpunkt $t_2$ wiederum die Strangströme zu erfassen und in den folgenden Schritten erneut auszuwerten.

Liegt der Differenzstrom $\Delta I_{max}$ oberhalb des zu-

lässigen Grenzwerts $I_G$, geht es über den Zweig 800 der Entscheidungsraute 600 zum nächsten Schritt 900, in dem ein Signal generiert wird, welches zur Ansteuerung der elektronischen Schalter, insbesondere der MOSFET's herangezogen werden kann, um den Akkupack z. B. auszuschalten. Das Ablaufdiagramm läuft auf Stopp.

**Patentansprüche**

1. Schutzschaltung mit einer Auswerteeinheit (10) zum Schutz einer Anordnung aus einer Vielzahl von Einzelzellen (4) in einem Akkupack (1), wobei eine vorgegebene Anzahl von Einzelzellen (4) in einer Zellreihe (A, B, C, D) hintereinander geschaltet sind, und zumindest zwei Zellreihen (A, B, C, D) zueinander parallel liegen, wobei die Schutzschaltung ausgebildet ist, den bei Belastung des Akkupacks (1) in einer ersten Zellreihe (A, B, C, D) fließenden Strangstrom ($I_a$, $I_b$, $I_c$, $I_d$) mit dem in einer zweiten Zellreihe (D, C, B, A) fließenden Strangstrom ($I_d$, $I_c$, $I_b$, $I_a$,) zu vergleichen, **dadurch gekennzeichnet, dass** in jeder Zellreihe (A, B, C, D) ein von der Auswerteeinheit (10) gesteuerter Schalter ($M_a$, $M_b$, $M_c$, $M_d$) angeordnet ist, und die am Schalter ($M_a$, $M_b$, $M_c$, $M_d$) abfallende Spannung ($U_a$, $U_b$, $U_c$) als proportionale Größe zu einem fließenden Strangstrom ($I_a$, $I_b$, $I_c$, $I_d$) erfasst und ausgewertet wird, und bei nicht plausibler Abweichung der Strangströme ($I_a$, $I_b$, $I_c$, $I_d$) voneinander ein Signal generiert wird.

2. Schutzschaltung nach Anspruch 1, **dadurch gekennzeichnet, dass** das Signal generiert wird, wenn eine Differenz der Strangströme ($I_a$, $I_b$, $I_c$, $I_d$) einen vorgegebenen Wert ($I_G$) überschreitet.

3. Schutzschaltung nach Anspruch 1 oder 2, **dadurch gekennzeichnet, dass** das Signal generiert wird, wenn eine Differenz der normierten Strangströme ($I_a$, $I_b$, $I_c$, $I_d$) einen vorgegebenen Wert ($I_G$) überschreitet.

4. Schutzschaltung nach einem der Ansprüche 1 bis 3, **dadurch gekennzeichnet, dass** die nicht plausible Abweichung aus dem Verhältnis (V) der Strangströme ($I_a$, $I_b$, $I_c$, $I_d$) zueinander abgeleitet ist.

5. Schutzschaltung nach einem der Ansprüche 1 bis 4, **dadurch gekennzeichnet, dass** die nicht plausible Abweichung aus einem Vorzeichenwechsel der Vorzeichen der Strangströme ($I_a$, $I_b$, $I_c$, $I_d$) abgeleitet ist.

6. Schutzschaltung nach einem der Ansprüche 1 bis 5, **dadurch gekennzeichnet, dass** die erfassten Strangströme ($I_a$, $I_b$, $I_c$, $I_d$) mit der Anzahl der in einer Zellreihe (A, B, C, D) parallel liegenden Einzelzellen (4) normiert sind.

7. Schutzschaltung nach einem der Ansprüche 1 bis 6, **dadurch gekennzeichnet, dass** die nicht plausible Abweichung aus einem Vergleich eines aus den Beträgen der Strangströme ($I_a$, $I_b$, $I_c$, $I_d$) gebildeten Summenstroms mit einem Gesamtstrom ($I_G$) abgeleitet ist.

8. Schutzschaltung nach einem der Ansprüche 1 bis 7, **dadurch gekennzeichnet, dass** aus den erfassten Strangströmen ($I_a$, $I_b$, $I_c$, $I_d$) ein maximaler Strangstrom ($I_{max}$) festgestellt ist, dass zwischen dem maximalen Strangstrom ($I_{max}$) und den anderen Strangströmen ($I_a$, $I_b$, $I_c$, $I_d$) ein Differenzstrom ($\Delta I_i$) ermittelt und zumindest ein Differenzstrom ($\Delta I_i$) mit einem Grenzwert ($I_G$) verglichen wird.

9. Schutzschaltung nach einem der Ansprüche 1 bis 8, **dadurch gekennzeichnet, dass** den Strangströmen ($I_a$, $I_b$, $I_c$, $I_d$) entsprechende Messwerte der Auswerteeinheit (10) zugeführt sind, in der die Prüfung der Plausibilität erfolgt und die bei nicht plausibler Abweichung das Signal abgibt.

10. Schutzschaltung nach Anspruch 1, **dadurch gekennzeichnet, dass** der Schalter ($M_a$, $M_b$, $M_c$, $M_d$) ein elektronischer Schalter ist, insbesondere ein MOSFET ist.

11. Schutzschaltung nach einem der Ansprüche 1 bis 10, **dadurch gekennzeichnet, dass** der Akkupack (1) aus mehr als zwei parallelen Zellreihen (A, B, C, D) aufgebaut ist und die in allen Zellreihen (A, B, C, D) fließenden Strangströme ($I_a$, $I_b$, $I_c$, $I_d$) untereinander verglichen werden.

12. Schutzschaltung nach einem der Ansprüche 1 bis 11, **dadurch gekennzeichnet, dass** zwischen den Einzelzellen (4) der Zellreihen (A, B, C, D) liegende Zellverbinder ($Z_{na}$, $Z_{nb}$, $Z_{nc}$, $Z_{nd}$) über eine Ausgleichsleitung ($L_{na}$, $L_{nb}$, $L_{nc}$) mit dem an einer gleichen Stelle der parallelen Zellreihe (A, B, C, D) liegenden Zellverbinder ($Z_{na}$, $Z_{nb}$, $Z_{nc}$, $Z_{nd}$) elektrisch verbunden sind und das Potenzial ($U_{nr}$, $U_{nl}$) des mit der Ausgleichsleitung ($L_{na}$, $L_{nb}$, $L_{nc}$) verbundenen Zellverbinders ($Z_{na}$, $Z_{nb}$, $Z_{nc}$, $Z_{nd}$) der einen Stelle der einen Zellreihe (A, B, C, D) erfasst wird sowie das Potenzial ($U_{nr}$, $U_{nl}$) des mit der Ausgleichsleitung ($L_{na}$, $L_{nb}$, $L_{nc}$) elektrisch verbundenen Zellverbinders ($Z_{na}$, $Z_{nb}$, $Z_{nc}$, $Z_{nd}$) an der gleichen Stelle der parallelen Zellreihe (A, B, C, D) erfasst wird und die erfassten Potenziale ($U_{nr}$, $U_{nl}$) der Auswerteeinheit (10) zugeführt sind.

13. Schutzschaltung nach Anspruch 12, **dadurch gekennzeichnet, dass** die erfassten Potenziale ($U_{nr}$, $U_{nl}$) untereinander ausgewertet wer-

den und abhängig vom Ergebnis der Auswertung ein weiteres Signal generiert wird, wobei die erfassten Potenziale ($U_{nr}$, $U_{nl}$) direkt miteinander verglichen werden.

14. Schutzschaltung nach Anspruch 12 und 13,
**dadurch gekennzeichnet, dass** aus den erfassten Potenzialen ($U_{nr}$, $U_{nl}$) der Zellverbinder ($Z_{na}$, $Z_{nb}$, $Z_{nc}$) einer gleichen Stelle paralleler Zellreihen (A, B, C, D) eine Differenzspannung ($\Delta U$) abgeleitet und mit einem vorgegebenen Schwellwert ($Us$) verglichen wird, wobei abhängig vom Überschreiten des Schwellwertes ($Us$) das weitere Signal generiert wird.

15. Schutzschaltung nach einem der Ansprüche 12 bis 14,
**dadurch gekennzeichnet, dass** die Zellreihen (A, B, C, D) in einem Gehäuse (7) des Akkupacks (1) angeordnet sind und im Gehäuse (7) die Auswerteeinheit (10) vorgesehen ist, der die Potenziale ($U_{nr}$, $U_{nl}$) der mit Ausgleichsleitungen ($L_{na}$, $L_{nb}$, $L_{nc}$) verbundenen Zellverbinder ($Z_{na}$, $Z_{nb}$, $Z_{nc}$, $Z_{nd}$) der einen Zellreihe (A, B, C, D) und die erfassten Potenziale ($U_{nr}$, $U_{nl}$) der zugeordneten Zellverbinder ($Z_{na}$, $Z_{nb}$, $Z_{nc}$, $Z_{nd}$) einer parallelen Zellreihe (A, B, C, D) zugeführt sind.

16. Schutzschaltung nach einem der Ansprüche 12 bis 14,
**dadurch gekennzeichnet, dass** im Akkupack (1) mehrere Zellreihen (A, B, C, D) zueinander parallel liegen und alle an gleicher Stelle der parallelen Zellreihen (A, B, C, D) liegenden Zellverbinder ($Z_{na}$, $Z_{nb}$, $Z_{nc}$, $Z_{nd}$) über Ausgleichsleitungen ($L_{na}$, $L_{nb}$, $L_{nc}$) miteinander elektrisch verbunden sind, wobei vorzugsweise die Potenziale ($U_{nl}$) der Zellverbinder ($Z_{na}$) der ersten Zellreihe (A) der Parallelschaltung und die Potenziale ($U_{nr}$) der Zellverbinder ($Z_{nd}$) der letzten Zellreihe (D) der Parallelschaltung erfasst und ausgewertet werden.

17. Schutzschaltung nach Anspruch 1 und 12,
**dadurch gekennzeichnet, dass** die parallelen Zellreihen (A, B, C, D) der Einzelzellen (4) eine gedachte Matrix aus m-Zeilen von Einzelzellen (4) und n-Spalten von Zellreihen (A, B, C, D) bilden, wobei durch den Vergleich der Potenziale der Zellverbinder ($Z_{na}$, $Z_{nb}$, $Z_{nc}$, $Z_{nd}$) die Zeile n eines Defektes ermittelt und durch die Plausibilitätsprüfung der Strangströme ($I_a$, $I_b$, $I_c$, $I_d$) die Spalte m des Defektes bestimmt ist.

18. Schutzschaltung nach Anspruch 17,
**dadurch gekennzeichnet, dass** die nach dem Prinzip der Matrix festgestellte defekte Zellreihe (A, B, C, D) durch den Schalter ($M_a$, $M_b$, $M_c$, $M_d$) abgeschaltet wird.

19. Schutzschaltung nach einem der Ansprüche 1 bis 18,
**dadurch gekennzeichnet, dass** das Signal als Steuersignal zum Abschalten einer Zellreihe (A, B, C, D) oder des gesamten Akkupacks (1) durch einen oder mehrere Schalter ($M_a$, $M_b$, $M_c$, $M_d$; 40, 43) herangezogen wird.

**Claims**

1. Protective circuit having an evaluation unit (10) to protect an arrangement of a plurality of individual cells (4) in a battery pack (1), wherein a predefined number of individual cells (4) are arranged one behind the other in a cell row (A, B, C, D), and at least two cell rows (A, B, C, D) lie parallel to each other, wherein the protective circuit is configured to compare, when the battery back (1) is loaded, phase current ($I_a$, $I_b$, $I_c$, $I_d$) flowing in a first cell row (A, B, C, D) with the phase current ($I_d$, $I_c$, $I_b$, $I_a$) flowing in a second cell row (D, C, B, A), **characterised in that** a switch ($M_a$, $M_b$, $M_c$, $M_d$) controlled by the evaluation unit (10) is arranged in each cell row (A, B, C, D), and the voltage ($U_a$, $U_b$, $U_c$) falling at the switch ($M_a$, $M_b$, $M_c$, $M_d$) is detected as a proportional value to a flowing phase current ($I_a$, $I_b$, $I_c$, $I_d$) and evaluated, and in the case of an implausible deviation of the phase currents ($I_a$, $I_b$, $I_c$, $I_d$) from each other a signal is generated.

2. Protective circuit according to claim 1, **characterised in that** the signal is generated if a difference between the phase currents ($I_a$, $I_b$, $I_c$, $I_d$) exceeds a predefined value ($I_G$).

3. Protective circuit according to claim 1 or 2, **characterised in that** the signal is generated if a difference between the normalised phase currents ($I_a$, $I_b$, $I_c$, $I_d$) exceeds a predefined value ($I_G$).

4. Protective circuit according to one of claims 1 to 3, **characterised in that** the implausible deviation is derived from the ratio (V) of the phase currents ($I_a$, $I_b$, $I_c$, $I_d$) to each other.

5. Protective circuit according to one of claims 1 to 4, **characterised in that** the implausible deviation is derived from a change in the sign of the phase currents ($I_a$, $I_b$, $I_c$, $I_d$).

6. Protective circuit according to one of claims 1 to 5, **characterised in that** the detected phase currents ($I_a$, $I_b$, $I_c$, $I_d$) are normalised with the number of the individual cells (4) lying in parallel in a cell row (A, B, C, D).

7. Protective circuit according to one of claims 1 to 6,

**characterised in that** the implausible deviation is derived from a comparison of a sum of the current formed by the amounts of the phase currents ($I_a$, $I_b$, $I_c$, $I_d$) with a total current ($I_G$).

8. Protective circuit according to one of claims 1 to 7, **characterised in that** a maximum phase current ($I_{max}$) is determined from the detected phase currents ($I_a$, $I_b$, $I_c$, $I_d$), a differential current ($\Delta I_i$) is determined between the maximum phase current ($I_{max}$) and the other phase currents ($I_a$, $I_b$, $I_c$, $I_d$), and at least one differential current ($\Delta I_i$) is compared with a threshold value ($I_G$).

9. Protective circuit according to one of claims 1 to 8, **characterised in that** measurement values corresponding to the phase currents ($I_a$, $I_b$, $I_c$, $I_d$) are supplied to the evaluation unit (10), in which the plausibility check is carried out, and which emits the signal in the case of an implausible deviation.

10. Protective circuit according to claim 1, **characterised in that** the switch ($M_a$, $M_b$, $M_c$, $M_d$) is an electronic switch, in particular a MOSFET.

11. Protective circuit according to one of claims 1 to 10, **characterised in that** the battery pack (1) is constructed from more than two parallel cell rows (A, B, C, D) and the phase currents ($I_a$, $I_b$, $I_c$, $I_d$) flowing in all cell rows (A, B, C, D) are compared with each other.

12. Protective circuit according to one of claims 1 to 11, **characterised in that** cell connectors ($Z_{na}$, $Z_{nb}$, $Z_{nc}$, $Z_{nd}$) lying between the individual cells (4) of the cell rows (A, B, C, D) are electrically connected via a balance line ($L_{na}$, $L_{nb}$, $L_{nc}$) to the cell connector ($Z_{na}$, $Z_{nb}$, $Z_{nc}$, $Z_{nd}$) lying at an equal position of the parallel cell row (A, B, C, D), and the potential ($U_{nr}$, $U_{nl}$) of the cell connector ($Z_{na}$, $Z_{nb}$, $Z_{nc}$, $Z_{nd}$), connected to the balance line ($L_{na}$, $L_{nb}$, $I_{nc}$), of the one position of the one cell row (A, B, C, D) is detected and also the potential ($U_{nr}$, $U_{nl}$) of the cell connector ($Z_{na}$, $Z_{nb}$, $Z_{nc}$, $Z_{nd}$), electrically connected to the balance line ($L_{na}$, $L_{nb}$, $L_{nc}$), at an equal position of the parallel cell row (A, B, C, D) is detected, and the detected potentials ($U_{nr}$, $U_{nl}$) are supplied to the evaluation unit (10).

13. Protective circuit according to claim 12, **characterised in that** the detected potentials ($U_{nr}$, $U_{nl}$) are evaluated among themselves and a further signal is generated depending on the result of the evaluation, wherein the detected potentials ($U_{nr}$, $U_{nl}$) are directly compared with each other.

14. Protective circuit according to claims 12 and 13, **characterised in that** a differential voltage ($\Delta U$) is derived from the detected potentials ($U_{nr}$, $U_{nl}$) of the cell connectors ($Z_{na}$, $Z_{nb}$, $Z_{nc}$) of an equal position of parallel cell rows (A, B, C, D) and is compared with a predefined threshold value ($U_s$), wherein the further signal is generated depending on exceeding of the threshold value ($U_s$).

15. Protective circuit according to one of claims 12 to 14, **characterised in that** the cell rows (A, B, C, D) are arranged in a housing (7) of the battery pack (1) and the evaluation unit (10) is provided in the housing (7), to which the potentials ($U_{nr}$, $U_{nl}$) of the cell connectors ($Z_{na}$, $Z_{nb}$, $Z_{nc}$, $Z_{nd}$), of the one cell row (A, B, C, D), connected to balance lines ($L_{na}$, $L_{nb}$, $L_{nc}$) and the detected potentials ($U_{nr}$, $U_{nl}$) of the assigned cell connectors ($Z_{na}$, $Z_{nb}$, $Z_{nc}$, $Z_{nd}$) of a parallel cell row (A, , B, C, D) are supplied.

16. Protective circuit according to one of claims 12 to 14, **characterised in that** a plurality of cell rows (A, B, C, D) lie parallel to each other in the battery pack (1) and all cell connectors ($Z_{na}$, $Z_{nb}$, $Z_{nc}$, $Z_{nd}$) lying at an equal position of the parallel cell rows (A, B, C, D) are electrically connected to each other via balance lines ($L_{na}$, $L_{nb}$, $L_{nc}$), wherein preferably the potentials ($U_{nl}$) of the cell connectors ($Z_{na}$) of the first cell row (A) of the parallel circuit and the potentials ($U_{nr}$) of the cell connectors ($Z_{nd}$) of the last cell row (D) of the parallel circuit are detected and evaluated.

17. Protective circuit according to claims 1 and 12, **characterised in that** the parallel cell rows (A, B, C, D) of the individual cells (4) form a notional matrix of m lines of individual cells (4) and n columns of cell rows (A, B, C, D), wherein by comparing the potentials of the cell connectors ($Z_{na}$, $Z_{nb}$, $Z_{nc}$, $Z_{nd}$) the line n of a defect is ascertained, and the column m of the defect is determined by the plausibility check of the phase currents ($I_a$, $I_b$, $I_c$, $I_d$).

18. Protective circuit according to claim 17, **characterised in that** the defective cell row (A, B, C, D) ascertained according to the principle of the matrix is disconnected by the switch ($M_a$, $M_b$, $M_c$, $M_d$).

19. Protective circuit according to one of claims 1 to 18, **characterised in that** the signal is used as a control signal to disconnect a cell row (A, B, C, D) or the whole battery pack (1) by one or a plurality of switches ($M_a$, $M_b$, $M_c$, $M_d$; 40, 43).

**Revendications**

1. Circuit protecteur avec une unité d'analyse (10) pour protéger un dispositif composé d'une multiplicité d'éléments individuels (4) dans une batterie (1), un nombre prédéfini d'éléments individuels (4) étant montés les uns derrière les autres dans une rangée d'éléments (A, B, C, D), et au moins deux rangées d'éléments (A, B, C, D) étant parallèles, le circuit protecteur étant conçu pour comparer le courant de phase ($I_a$, $I_b$, $I_c$, $I_d$) qui passe dans une première rangée d'éléments (A, B, C, D) lors d'une sollicitation de la batterie (1) au courant de phase (($I_d$, $I_c$, $I_b$, $I_a$) qui passe dans une deuxième rangée d'éléments (D, C, B, A), **caractérisé en ce que** dans chaque rangée d'éléments (A, B, C, D) est disposé un commutateur ($M_a$, $M_b$, $M_c$, $M_d$) commandé par l'unité d'analyse (10), et la tension ($U_a$, $U_b$, $U_c$) qui baisse au niveau du commutateur ($M_a$, $M_b$, $M_c$, $M_d$) est détectée et analysée comme grandeur proportionnelle par rapport à un courant de phase ($I_a$, $I_b$, $I_c$, $I_d$) qui passe, et en cas d'écart non plausible entre les courants de phase ($I_a$, $I_b$, $I_c$, $I_d$), un signal est généré.

2. Circuit protecteur selon la revendication 1, **caractérisé en ce que** le signal est généré si une différence des courants de phase ($I_a$, $I_b$, $I_c$, $I_d$) dépasse une valeur prédéfinie ($I_G$).

3. Circuit protecteur selon la revendication 1 ou 2, **caractérisé en ce que** le signal est généré si une différence des courants de phase ($I_a$, $I_b$, $I_c$, $I_d$) normés dépasse une valeur prédéfinie ($I_G$).

4. Circuit protecteur selon l'une des revendications 1 à 3, **caractérisé en ce que** l'écart non plausible est dérivé du rapport (V) des courants de phase ($I_a$, $I_b$, $I_c$, $I_d$) les uns par rapport aux autres.

5. Circuit protecteur selon l'une des revendications 1 à 4, **caractérisé en ce que** l'écart non plausible est dérivé d'un changement de signe des courants de phase ($I_a$, $I_b$, $I_c$, $I_d$).

6. Circuit protecteur selon l'une des revendications 1 à 5, **caractérisé en ce que** les courants de phase ($I_a$, $I_b$, $I_c$, $I_d$) détectés sont normés avec le nombre d'éléments individuels (4) placés parallèlement dans une rangée d'éléments (A, B, C, D).

7. Circuit protecteur selon l'une des revendications 1 à 6, **caractérisé en ce que** l'écart non plausible est dérivé d'une comparaison d'un courant cumulé, formé à partir des valeurs des courants de phase ($I_a$, $I_b$, $I_c$, $I_d$), à un courant total ($I_G$).

8. Circuit protecteur selon l'une des revendications 1 à 7, **caractérisé en ce qu'**à partir des courants de phase ($I_a$, $I_b$, $I_c$, $I_d$) détectés est constaté un courant de phase maximal ($I_{max}$), **en ce qu'**un courant différentiel ($\Delta I_i$) est déterminé entre le courant de phase maximal ($I_{max}$) et les autres courants de phase ($I_a$, $I_b$, $I_c$, $I_d$), et au moins un courant différentiel ($\Delta I_i$) est comparé à une valeur limite ($I_G$).

9. Circuit protecteur selon l'une des revendications 1 à 8, **caractérisé en ce que** des valeurs de mesure de l'unité d'analyse (10) qui correspondent aux courants de phase ($I_a$, $I_b$, $I_c$, $I_d$) sont transmises à l'unité d'analyse (10), dans laquelle a lieu le contrôle de plausibilité et qui émet le signal en cas d'écart non plausible.

10. Circuit protecteur selon la revendication 1, **caractérisé en ce que** le commutateur ($M_a$, $M_b$, $M_c$, $M_d$) est un commutateur électronique, en particulier un MOSFET.

11. Circuit protecteur selon l'une des revendications 1 à 10, **caractérisé en ce que** la batterie (5) se compose de plus de deux rangées d'éléments (A, B, C, D) parallèles, et les courants de phase ($I_a$, $I_b$, $I_c$, $I_d$) qui passent dans toutes les rangées d'éléments (A, B, C, D) sont comparés entre eux.

12. Circuit protecteur selon l'une des revendications 1 à 11, **caractérisé en ce que** des connecteurs d'éléments ($Z_{na}$, $Z_{nb}$, $Z_{nc}$, $Z_{nd}$) placés entre les éléments individuels (4) des rangées d'éléments (A, B, C, D) sont reliés électriquement, par l'intermédiaire d'une ligne de compensation ($L_{na}$, $L_{nb}$, $L_{nc}$), au connecteur d'éléments ($Z_{na}$, $Z_{nb}$, $Z_{nc}$, $Z_{nd}$) placé à un même endroit de la rangée d'éléments (A, B, C, D) parallèle, et le potentiel ($U_{nr}$, $U_{nl}$) du connecteur d'éléments ($Z_{na}$, $Z_{nb}$, $Z_{nc}$, $Z_{nd}$), relié à la ligne de compensation ($L_{na}$, $L_{nb}$, $L_{nc}$), d'un endroit d'une rangée d'éléments (A, B, C, D) est détecté et le potentiel ($U_{nr}$, $U_{nl}$) du connecteur d'éléments ($Z_{na}$, $Z_{nb}$, $Z_{nc}$, $Z_{nd}$), relié électriquement à la ligne de compensation ($L_{na}$, $L_{nb}$, $L_{nc}$), au même endroit de la rangée d'éléments (A, B, C, D) parallèle est détecté et les potentiels ($U_{nr}$, $U_{nl}$) détectés sont transmis à l'unité d'analyse (10).

13. Circuit protecteur selon la revendication 12, **caractérisé en ce que** les potentiels ($U_{nr}$, $U_{nl}$) détectés sont analysés entre eux, et en fonction du résultat de l'analyse un autre signal est généré, les potentiels ($U_{nr}$, $U_{nl}$) détectés étant comparés directement l'un à l'autre.

14. Circuit protecteur selon les revendications 12 et 13, **caractérisé en ce qu'**une tension différentielle ($\Delta U$) est dérivée des potentiels ($U_{nr}$, $U_{nl}$) détectés des connecteurs d'éléments ($Z_{na}$, $Z_{nb}$, $Z_{nc}$) d'un même endroit de rangées d'éléments (A, B, C, D) parallèles, et est comparée à une valeur seuil prédéfinie (Us), ledit autre signal étant généré en fonction du dépassement de la valeur seuil (Us).

15. Circuit protecteur selon l'une des revendications 12 à 14,

   **caractérisé en ce que** les rangées d'éléments (A, B, C, D) sont disposées dans un boîtier (7) de la batterie (1), et dans le boîtier (7) est prévue l'unité d'analyse (10) à laquelle sont transmis les potentiels ($U_{nr}$, $U_{nl}$) des connecteurs d'éléments ($Z_{na}$, $Z_{nb}$, $Z_{nc}$, $Z_{nd}$), reliés aux lignes de compensation ($L_{na}$, $L_{nb}$, $L_{nc}$,), d'une rangée d'éléments (A, B, C, D) et les potentiels ($U_{nr}$, $U_{nl}$) détectés des connecteurs d'éléments ($Z_{na}$, $Z_{nb}$, $Z_{nc}$, $Z_{nd}$) associés d'une rangée d'éléments (A, B, C, D) parallèle.

16. Circuit protecteur selon l'une des revendications 12 à 14,

   **caractérisé en ce que** dans la batterie (1), plusieurs rangées d'éléments (A, B, C, D) sont parallèles et tous les connecteurs d'éléments ($Z_{na}$, $Z_{nb}$, $Z_{nc}$, $Z_{nd}$) placés à un même endroit des rangées d'éléments (A, B, C, D) parallèles sont reliés électriquement par l'intermédiaire de lignes de compensation ($L_{na}$, $L_{nb}$, $L_{nc}$), les potentiels ($U_{nl}$) des connecteurs d'éléments ($Z_{na}$) de la première rangée d'éléments (A) du montage parallèle et les potentiels ($U_{nr}$) des connecteurs d'éléments ($Z_{nd}$) de la dernière rangée d'éléments (D) du montage parallèle étant de préférence détectés et analysés.

17. Circuit protecteur selon les revendications 1 et 12,
   **caractérisé en ce que** les rangées (A, B, C, D) parallèles d'éléments individuels (4) forment une matrice imaginaire composée de m lignes d'éléments individuels (4) et de n colonnes de rangées d'éléments (A, B, C, D), la rangée n d'un défaut étant déterminée grâce à la comparaison des potentiels des connecteurs d'éléments ($Z_{na}$, $Z_{nb}$, $Z_{nc}$, $Z_{nd}$), et la colonne m du défaut étant définie grâce au contrôle de plausibilité des courants de phase ($I_a$, $I_b$, $I_c$, $I_d$).

18. Circuit protecteur selon la revendication 17,
   **caractérisé en ce que** la rangée d'éléments (A, B, C, D) défectueuse constatée suivant le principe de la matrice est déconnectée par le commutateur ($M_a$, $M_b$, $M_c$, $M_d$).

19. Circuit protecteur selon l'une des revendications 1 à 18,

   **caractérisé en ce que** le signal est utilisé comme signal de commande pour la déconnexion d'une rangée d'éléments (A, B, C, D) ou de toute la batterie (1) par un ou plusieurs commutateurs ($M_a$, $M_b$, $M_c$ ; 40, 43).

**FIG. 1**

**FIG. 2**

**FIG. 3**

**FIG. 4**

100 — $I_a$, $I_b$, $I_c$, $I_d$

200 — $I_{a,n}$, $I_{b,n}$, $I_{c,n}$, $I_{d,n}$

300 — $I_{max}$

400 — $\Delta I_i = I_{max} - I_i$

500 — $\Delta I_{max}$

700

600 — $\Delta I_{max} > I_G$ — Nein

Ja

800

900 — MOSFETS AUS

STOP

**FIG. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1308739 A2
- US 20110003182 A1
- US 20110074354 A1